(19) Europäisches Patentamt
European Patent Office
Office européen des brevets

(11) **EP 3 916 939 B1**

(12) **EUROPÄISCHE PATENTSCHRIFT**

(45) Veröffentlichungstag und Bekanntmachung des Hinweises auf die Patenterteilung:
**11.10.2023 Patentblatt 2023/41**

(21) Anmeldenummer: **20176256.4**

(22) Anmeldetag: **25.05.2020**

(51) Internationale Patentklassifikation (IPC):
**H02H 3/00** (2006.01)    **H02J 3/18** (2006.01)
**H02J 3/20** (2006.01)    **H02H 7/26** (2006.01)

(52) Gemeinsame Patentklassifikation (CPC):
**H02H 3/006; H02J 3/1821; H02J 3/20;** H02H 7/26;
Y02E 40/30

(54) **VERFAHREN FÜR EINEN LEITUNGSSCHUTZ UND SCHUTZANORDNUNG**

METHOD FOR LINE PROTECTION AND PROTECTION ARRANGEMENT

PROCÉDÉ POUR UNE PROTECTION DE CONDUITES ET AGENCEMENT DE PROTECTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.12.2021 Patentblatt 2021/48**

(73) Patentinhaber: **Siemens Aktiengesellschaft**
**80333 München (DE)**

(72) Erfinder: **Steynberg, Friedemann Gustav**
**91338 Igensdorf (DE)**

(74) Vertreter: **Siemens Patent Attorneys**
**Postfach 22 16 34**
**80506 München (DE)**

(56) Entgegenhaltungen:
**EP-A1- 3 629 437     WO-A1-2017/045044**
**US-B1- 8 744 637**

- **Siemens AG 2016, Energy Management Division: "SIPROTEC 5 Schutz, Automatisierung und Überwachung", EMDG-B10022-00, 2016, XP002800769, Internet Gefunden im Internet: URL:https://www.downloads.siemens.com/dow n load-center/download?DLA09_248 [gefunden am 2020-10-21]**
- **Siemens AG, Energy Management Division: "SIPROTEC 7SD87 Leitungsdifferentialschutz", SIPROTEC 7SD87 Steckbrief E7.8.docx, August 2018 (2018-08), XP002800770, Gefunden im Internet: URL:https://www.downloads.siemens.com/dow n load-center/Download.aspx?pos=download&fct =getasset&mandator=ic_sg&id1=DLA07_1698 [gefunden am 2020-10-21]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 916 939 B1

**EP 3 916 939 B1**

**Beschreibung**

Die Erfindung betrifft ein Verfahren für einen Leitungsschutz nach dem Oberbegriff des Anspruchs 1 sowie eine Schutzanordnung nach dem Oberbegriff des Anspruchs 6.

Auf längeren Freileitungen und Kabeln wird typischerweise eine Drosseleinrichtung installiert, um einem kapazitiven Blindstrom auf der Leitung zu kompensieren. Wenn ein Stromwandler auf der Leitungsseite der Drossel installiert ist, wird nach dem Öffnen eines Leistungsschalters ein abklingender Resonanzstrom gemessen. Dieser Resonanzstrom hat einen nachteiligen Effekt auf Funktionen eines Schutzgeräts, die den Abschaltstrom bewerten. Bei den Funktionen handelt es sich z.B. um eine Absteuerung des Auskommandos und um einen Schalterversagerschutz. Bisher wird dieses Problem gelöst, indem für das Schutzgerät ein Einstellwert für den Mindeststrom bei offenem Leistungsschalter auf einen entsprechend großen Wert eingestellt wurde. Dadurch wird auch die Stromschwelle beim Schalterversagerschutz entsprechend groß eingestellt. Damit sind beide Funktionen des Schutzgeräts jedoch deutlich in ihrer Empfindlichkeit eingeschränkt.

Aus der Broschüre "SIPROTEC 7SD87 Leitungsdifferentialschutz", Siemens AG 2018 ist ein Erweiterungsmodul für einen Leitungsschutz bekannt. Dieses kann mit einem aus der Broschüre "SIPROTEC 5 Schutz, Automatisierung und Überwachung", Siemens AG 2016, Artikel-Nr.: EMDG-B10022-00, bekannten Schutzgerät kombiniert werden.

Aus der Druckschrift EP 3 629 437 A1 ist ein Verfahren für einen Leitungsschutz bekannt.

An die Erfindung stellt sich die Aufgabe, ein Verfahren für einen Leitungsschutz anzugeben, das eine vergleichsweise hohe Sicherheit für den Leitungsschutz bereitstellt.

Die Erfindung löst diese Aufgabe durch ein Verfahren gemäß Anspruch 1.

Beispielsweise kann es sich bei der Drosseleinrichtung um eine Drosselspule handeln, die ggf. für mehrere Phasen ausgebildet ist. Im Folgenden werden die Begriffe Drossel, Drosselspule und Drosseleinrichtung synonym verwendet. Diese Induktivität wird entsprechend zur kapazitiven Blindleistungskompensation eingesetzt.

Z.B. kann die Leitung für dreiphasige Wechselspannung ausgebildet sein, so dass auch die Drosseleinrichtung und die Messeinrichtungen für drei Phasen ausgebildet werden. Es kann sich bei der Leitung z.B. um eine Hochspannungsleitung wie etwa eine Freileitung mit einer Nennspannung über 52 kV handeln.

Die Erfindung verwendet die gemessene Spannung um den Strom in der Drossel zu berechnen, und bestimmt dann durch Subtraktion einen berechneten Strom am Leistungsschalter. Nach öffnen des Leistungsschalters ist der berechnete Strom nicht von dem Ausgleichsstrom in der Drossel belastet. Dies ermöglicht eine geringere Auslöseempfindlichkeit des Schutzgeräts um Hinblick auf seine Funktionen wie beispielsweise Abschaltung eines Netzabschnitts und Schaltversagerschutz, was die Sicherheit des Betriebs der Leitung bzw. des Energienetzes erhöht.

Mit dem berechneten Strom kann die Stromschwelle zur Bestimmung des Offen-Zustand des Leistungsschalters wie gewohnt empfindlich eingestellt werden. Die Einschränkungen, welche der Einbau eines Stromwandlers auf der Leitungsseite der Drosselspule verursacht, werden beseitigt.

Die erste Messeinrichtung kann z.B. einen Stromwandler aufweisen und die zweite Messeinrichtung kann z.B. einen Spannungswandler aufweisen.

Bei der ersten und der zweiten Messeinrichtung kann es sich beispielsweise um separate Messgeräte handeln. Es kann jedoch alternativ auch ein einziges Messgerät eingesetzt werden, das beide Funktionen - Strom- und Spannungsmessung, in sich vereint. Dies hat den Vorteil, dass die Spannungs- und Stromwerte jeweils zu gleichen Zeitpunkten, z.B. mit gleichen Zeitstempeln, vorliegen, ohne dass eine Synchronisierung zwischen dem ersten und dem zweiten Messeinrichtungen erfolgen muss.

Die Ausgabewerte der Messeinrichtungen können z.B. per Prozessbus an die Auswerteeinrichtung und/oder die Schutzeinrichtung übertragen werden. Alternativ kann ein anderes digitales Datenübertragungsverfahren eingesetzt werden.

Als Auswerteeinrichtung kann ein Computer mit Prozessor- und Datenspeichermitteln eingesetzt werden. Die Auswerteeinrichtung kann jedoch auch in Software umgesetzt sein und als Funktion in der Schutzeinrichtung, die über eigene Prozessor- und Datenspeichermittel verfügt, ausgebildet sein.

In einer Varianten können die erste und die zweite Messeinrichtung Teil der Schutzeinrichtung sein. In einer Weiterbildung kann auch die Auswerteeinrichtung Teil der Schutzeinrichtung sein.

Ein Resonanzstrom im Sinne der Erfindung ist ein elektrischer Strom, der beim Abschalten der Leitung kurzzeitig messbar ist und über die Zeit abklingt.

In einer bevorzugten Ausführungsform des erfindungsgemäßen Verfahrens wird der korrigierte Strom von einer Schutzeinrichtung als Eingabegröße für Leitungsschutzfunktionen verwendet. Dies ist ein Vorteil, weil der verfälschende Einfluss der Drosselspule eliminiert werden kann.

In einer bevorzugten Ausführungsform des erfindungsgemäßen Verfahrens wird für die Schutzeinrichtung ein Schwellenwert zur Bestimmung des offenen Zustands des Leistungsschalters verwendet, wobei der Schwellenwert geringer ist als bei einer Verwendung des gemessenen Resonanzstromes als Eingabegröße. Dies ist ein Vorteil, weil

2

so eine höhere Auslöseempfindlichkeit der Schutzeinrichtung und damit eine verbesserte Sicherheit erzielt werden kann.

In einer bevorzugten Ausführungsform des erfindungsgemäßen Verfahrens wird für die Drosseleinrichtung ein Main Reactor Shunt und ein Neutral Reactor Shunt verwendet.

In einer bevorzugten Ausführungsform des erfindungsgemäßen Verfahrens wird der Strom in der Drosseleinrichtung für jede Phase jeweils durch eine Analyse Symmetrischer Komponenten ermittelt. Dies ist ein Vorteil, weil es sich um ein einfaches und erprobtes Verfahren handelt.

Ferner stellt sich an die Erfindung die Aufgabe, eine Schutzanordnung anzugeben, die eine vergleichsweise hohe Sicherheit für den Leitungsschutz bereitstellt.

Die Erfindung löst die Aufgabe durch eine Schutzanordnung gemäß Anspruch 6. Bevorzugte Ausführungsformen ergeben sich aus den abhängigen Ansprüchen 7 bis 10. Dabei ergeben sich sinngemäß die gleichen Vorteile wie eingangs für das erfindungsgemäße Verfahren erläutert.

Weiterhin stellt sich die Aufgabe, ein Verfahren anzugeben, mit dem die Sicherheit im Energienetz weiter erhöht werden kann.

Gelöst wird diese Aufgabe durch ein nicht beanspruchtes Verfahren für einen Leitungsschutz, bei dem an einer elektrischen Leitung eine Drosseleinrichtung zur Blindleistungskompensation vorgesehen wird, und auf der Leitungsseite der Drosseleinrichtung mittels einer ersten Messeinrichtung im geschlossenen Zustand eines Leistungsschalters ein erster Strom gemessen wird, dadurch gekennzeichnet, dass mittels einer zweiten Messeinrichtung im geschlossenen Zustand des Leistungsschalters eine Spannung gemessen wird, und dass mittels einer Auswerteeinrichtung anhand der gemessenen Spannung ein Strom in der Drosseleinrichtung berechnet wird, und mittels der Auswerteeinrichtung der berechnete Strom von dem gemessenen ersten Strom abgezogen wird, um einen korrigierten Strom zu erhalten.

In dieser nicht beanspruchten, alternativen Ausgestaltung kann auch vor dem Öffnen des Leistungsschalters - also im geschlossenen Zustand - jeweils für jede Phase der (erste) Strom (in diesem Fall also kein Resonanzstrom) und die Spannung gemessen werden, um einen korrigierten Strom zu berechnen.

In einer bevorzugten Ausführungsform wird der korrigierte Strom von einer Schutzeinrichtung als Eingabegröße für eine weitere Schutzfunktionen verwendet.

In einer bevorzugten Ausführungsform wird für die Schutzeinrichtung ein Schwellenwert zur Auslösung der weiteren Schutzfunktion verwendet wird, der Schwellenwert geringer ist als bei einer Verwendung des ersten Stromes als Eingabegröße. Bei der weiteren Schutzfunktion kann es sich z.B. um eine Fehlerortung und/oder einen Distanzschutz handeln. Dies ist ein Vorteil, weil durch die erfindungsgemäße genauere Erfassung des Stromes für die genannten weiteren Schutzfunktionen verbesserte Ergebnisse und damit eine erhöhte Sicherheit im Energienetz erreicht werden können.

Zur weiteren Erläuterung der Erfindung zeigen in schematischer Darstellung die

Figur 1    ein erstes Energienetz, und

Figur 2    ein zweites Energienetz, und

Figur 3    ein Ersatzschaltbild für symmetrische Komponenten, und

Figur 4    eine Simulation für einen dreiphasigen Stromverlauf.

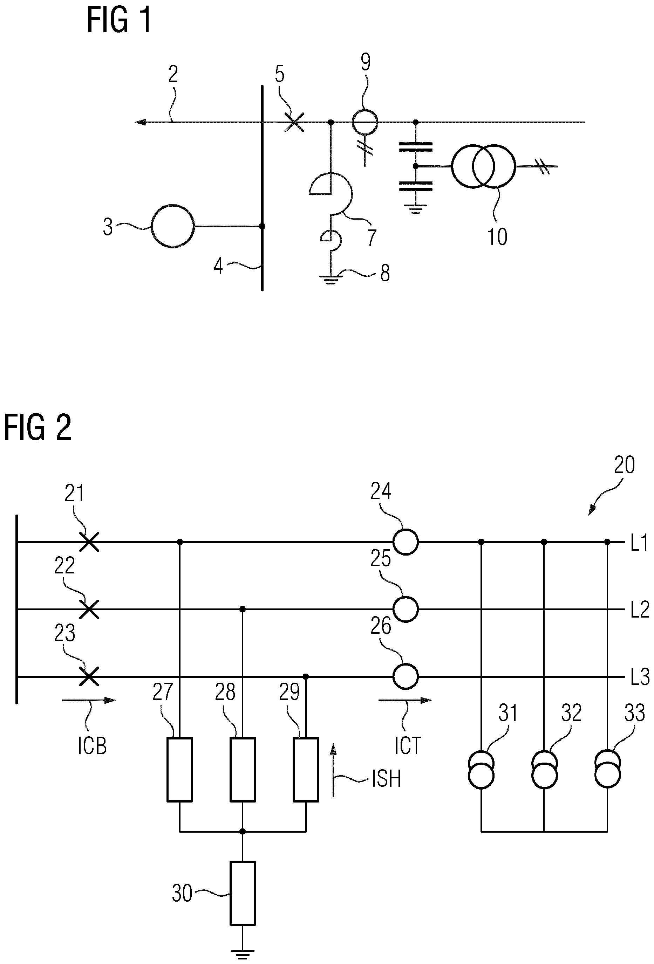

Die Figur 1 zeigt eine sog. Single-line Darstellung (einphasige Darstellung) 1 einer elektrischen Leitung 2 der Länge 360 km. An einer Sammelschiene 4 ist eine Einspeisung elektrischer Energie 3, z.B. eine Photovoltaikanlage, vorgesehen. Entlang der Leitung 2 ist einem Leistungsschalter 5 eine Drosselspule 7,8 nachgeordnet. Die Drosselspule weist einen sog. "Main Reactor shunt" 7 und einen sogenannten "Neutral Reactor shunt" 8 auf. Der Drosselspule 7,8 ist leitungsseitig ein Stromwandler als erste Messeinrichtung nachgeordnet. Der Stromwandler misst einen Resonanzstrom, der bei solch langen Leitungen aufgrund von Resonanzeffekten bei Öffnen des Leistungsschalters 5 kurzzeitig einen vergleichsweise großen Wert annehmen kann. Dieser Stromwert kann oberhalb einer Auslöseschwelle eines Schutzgeräts (nicht dargestellt) liegen, so dass dieses bestimmte Schutzfunktionen wie z.B. einen Schaltversagerschutz nicht durchführen kann.

Erfindungsgemäß wird vorgeschlagen, an der Leitung 2 (leitungsseitig in Bezug auf den Leistungsschalter, in der Figur 2 rechts dargestellt) einen Spannungswandler 10, der z.B. kapazitiv arbeitet, bzw. eine zweite Messeinrichtung anzuordnen, um eine in der Drosselspule anliegende Spannung zu messen. Anhand dieser Spannung kann jeweils auf den Strom in der Drossel rückgeschlossen und dieser Strom zur Korrektur des gemessenen Resonanzstromes eingesetzt werden.

Es ergeben sich beispielsweise folgende Werte:

|  |  | Main Reactor | Neutral Reactor |
|---|---|---|---|
| Induktivität Drossel | ($\Omega$) | 1600 | 1225 |
| Scheinleistung Drossel | (Mvar) | 100 | 100 |

Wenn der Leistungsschalter geöffnet wird, so entspricht der Strom, der in der ersten Messeinrichtung gemessen wird, dem durch die Drosselspule fließenden Strom. Dadurch könnte eine Auslösung ("trip") einer Schutzeinrichtung verzögert abgesteuert werden, falls dieser gemessene Strom größer ist als der Schwellenwert zur Bestimmung des abgeschalteten Zustands der Leitung 2 durch die Schutzeinrichtung (z.B. 50 mA).

Aus diesem Grund wird erfindungsgemäß vorgeschlagen, den gemessen Strom rechnerisch zu korrigieren, indem vom gemessenen Strom ein berechneter Stromfluss durch die Drosselspule abgezogen wird. Dieser Stromfluss durch die Spule wird anhand einer Spannungsmessung mittels eines Spannungswandlers als zweiter Messeinrichtung berechnet. Der Spannungswandler wird leitungsseitig in Bezug auf den Leistungsschalter angeordnet. Zur Berechnung wird außerdem eine berechnete Impedanz der Drosselspule herangezogen.

Ein äquivalenter Schaltplan 20 zum single-line diagramm der Figur 1 ist in Figur 2 dreiphasig dargestellt. Jede Phase L1,L2,L3 weist einen Leistungsschalter 21,22,23 auf, wobei für jede Phase im Leistungsschalter der gesuchte tatsächliche Strom $I_{CB}$ anliegt (für die Phase L3 mit einem Pfeil angedeutet). Ferner weist jede Phase eine Strommesseinrichtung 24,25,26 auf, an der jeweils der gemessene Strom $I_{CT}$ feststellbar ist. An einer Spannungsmesseinrichtung 31,32,33 für jede Phase wird die Spannung gemessen. Die Drosselspule 27-30 weist einen ersten Teil für den sog. "Main Reactor" mit einer Spule 27,28,29 pro Phase auf, wobei hier der zu berechnende Strom $I_{SH}$ fließt. Weiterhin ist ein sog. "Neutral Reactor" 30 vorgesehen.

Der Strom $I_{CB}$ am Leistungsschalter kann (für eine der Phasen) wie folgt berechnet werden:

$$I_{CB} = I_{CT} - I_{Sh}$$

Zur Berechnung von ISH wird die Phasenspannung herangezogen:

$$V_{Ph} = I_{Sh\_N} \cdot ZN_{Sh} + I_{Sh} \cdot ZL_{Sh}$$

Zur Lösung der geteilten Ströme in ZNSh und ZLSh werden für die Drosselspule sog. Symmetrische Komponenten analysiert. Die Analyse von Symmetrischen Komponenten ist in der Elektrotechnik ein gängiges Verfahren und z.B. von Wikipedia bekannt (permanenter Link: https://de.wikipedia.org/w/index.php?title=Symmetrische_Kompo nenten&oldid=198714718) .

$$I_{Sh\_A} = I1 + I2 + I0$$

Für die Phase A ergibt sich:

$$I_{Sh\_A} = \frac{V1}{Z_{sh}} + \frac{V2}{Z_{sh}} + \frac{V0}{3 \cdot ZN_{sh} + Z_{sh}}$$

$$I_{CB\_A} = I_{CT\_A} - \left( \frac{V1}{Z_{sh}} + \frac{V2}{Z_{sh}} + \frac{V0}{3 \cdot ZN_{sh} + Z_{sh}} \right)$$

Entsprechend können auch für die anderen beiden Phasen B,C anhand einer Analyse basierend auf symmetrischen Komponenten die Ströme am Leistungsschalter berechnet werden.

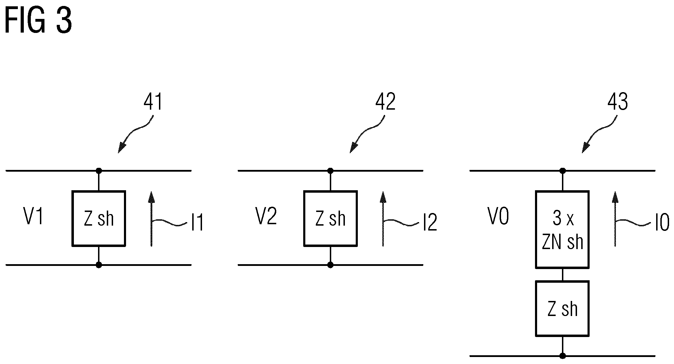

Die Figur 3 zeigt beispielhaft Ersatzschaltbilder 41-43 für die symmetrischen Komponenten Mit-, Gegen- und Null-System, wobei Mit- und Gegensystem identische Impedanzen $Z_{SH}$ aufweisen und das Nullsystem durch $Z_{SH}$ + 3* $ZN_{SH}$ definiert ist. Das Schaltbild 41 gibt das sogenannte Mitsystem, das Schaltbild 42 das Gegensystem und das Schaltbild 43 das Nullsystem an (vgl. o.g. Wikipedia-Artikel).

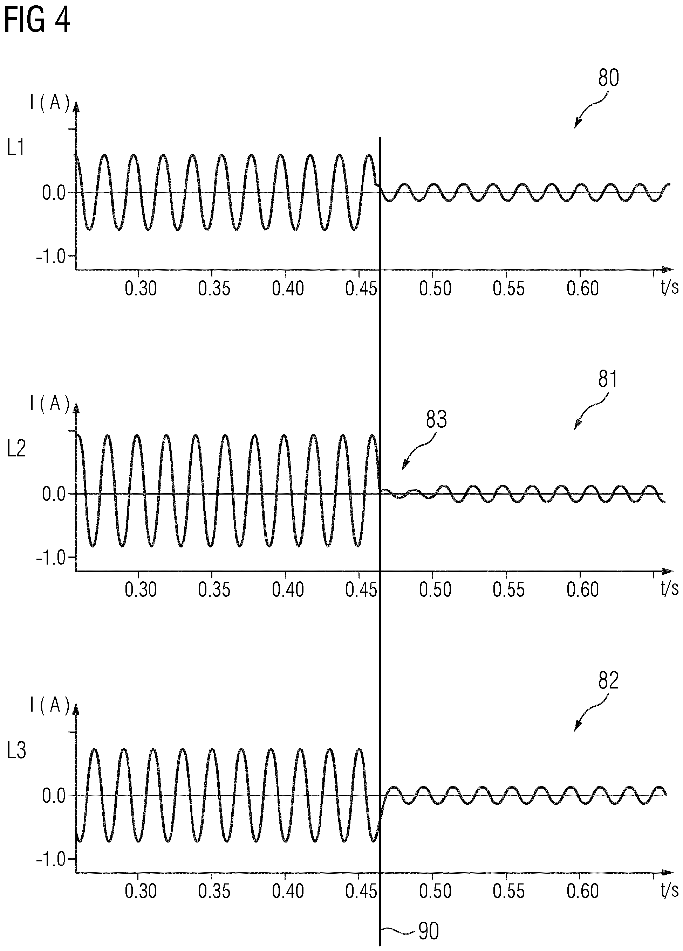

Die Figur 4 zeigt für die drei Phasen L1, L2 und L3 jeweils einen Verlauf für einen gemessenen Resonanzstrom 80,81,82. Dabei wurde bei t = 0 ms in der Simulation ein entfernter Kurzschluss auf der 350 km langen Leitung angelegt. Die Amplitude des Kurzschlussstromes I (A) ist jeweils zwischen 1A bis -1A (sekundärseitig, d.h. am Stromwandler) angegeben, wobei sich bei einem Übersetzungsverhältnis des Stromwandlers von 1000 beispielsweise eine Amplitude zwischen 1000 A bis-1000A primärseitig auf der Leitung ergibt.

Zum Zeitpunkt 460ms wird der Leistungsschalter in der Simulation geöffnet. Dies ist durch die senkrechte Linie 90 gekennzeichnet.

Für eine erste "Messung" nach 450 ms, also vor Öffnen des Leistungsschalters bei ca. 460 ms, ergeben sich folgende Werte (Zeigermessgrößen, jeweils mit Betrag (Länge) und Winkel angegeben):

| Messwert | Betrag | Winkel (°) |
|---|---|---|
| Strom Phase A | 417 mA | 135 |
| Strom Phase B | 629 mA | 89 |
| Strom Phase C | 519 mA | -108 |
| Spannung Phase A | 60,75 V | -49 |
| Spannung Phase C | 48,41 V | -169 |
| Spannung Phase C | 58,07 V | 80 |

Da zu diesem Zeitpunkt der Schalter noch geschlossen ist, wird der gemessene Strom nicht als Resonanzstrom bezeichnet. In den folgenden Beispielen - nach Öffnung des Schalters-wird der gemessene Strom als Resonanzstrom bezeichnet.

Aus den Messwerten ergeben sich folgende berechnete Werte:

| Berechnete Größe | Betrag | Winkel (°) |
|---|---|---|
| Mitsystem | 55,61 V | -46 |
| Gegensystem | 6,37 V | -86 |
| Nullsystem | 1,36 V | 36 |
| Korrigierter Strom Phase A | 424 mA | 147 |
| Korrigierter Strom Phase B | 696 mA | 91 |
| Korrigierter Strom Phase C | 505 mA | -99 |

Es ist deutlich erkennbar, dass der korrigierte Strom in Betrag und Phase - vor dem Öffnen des Leistungsschalters - jeweils nur wenig von dem gemessenen Strom abweicht.

Wird die Messung nach Öffnen des Leistungsschalters bei 500 ms wiederholt, also nach dem Öffnen des Leistungsschalters, so ergeben sich folgende Messwerte:

| Messwert | Betrag | Winkel (°) |
|---|---|---|
| Resonanzstrom Phase A | 89 mA | 62 |
| Resonanzstrom Phase B | 30 mA | -55 |
| Resonanzstrom Phase C | 88 mA | -170 |
| Spannung Phase A | 77,98 V | -12 |
| Spannung Phase B | 4,87 V | 27 |
| Spannung Phase C | 76,72 V | 81 |

Hieraus ergeben sich folgende berechnete Werte:

| Berechnete Größe | Betrag | Winkel (°) |
|---|---|---|
| Mitsystem | 48,44 V | -25 |
| Gegensystem | 15,85 V | -85 |

(fortgesetzt)

| Berechnete Größe | Betrag | Winkel (°) |
|---|---|---|
| Nullsystem | 37,41 V | 34 |
| Korrigierter Strom Phase A | 7 mA | -27 |
| Korrigierter Strom Phase B | 3 mA | -149 |
| Korrigierter Strom Phase C | 7 mA | 104 |

Durch die Korrektur des gemessenen Resonanzstromes ergeben sich sehr geringe korrigierte Ströme (unter 10 mA), die im Wesentlichen als Null (dies ist der Erwartungswert bei offenem Schalter) betrachtet werden können. Die korrigierten Ströme liegen unterhalb eines typischen Schwellenwerts von 50 mA, der bei Schutzeinrichtungen als noch vorhandener Stromfluss bei geschlossenem Leistungsschalter betrachtet wird.

Damit ermöglicht die Erfindung ein besseres Erkennen eines geöffneten Schalters für nachgeordnete Schutzeinrichtungen.

Bei 550 ms ergibt sich das Folgende:

| Messwert | Betrag | Winkel (°) |
|---|---|---|
| Resonanzstrom Phase A | 91 mA | 65 |
| Resonanzstrom Phase B | 91 mA | -54 |
| Resonanzstrom Phase C | 92 mA | -173 |
| Spannung Phase A | 63,14 V | -24 |
| Spannung Phase C | 60,95 V | -149 |
| Spannung Phase C | 65,59 V | 96 |

Hieraus ergeben sich folgende berechnete Werte:

| Berechnete Größe | Betrag | Winkel (°) |
|---|---|---|
| Mitsystem | 63,17 V | -26 |
| Gegensystem | 1,74 V | -43 |
| Nullsystem | 2,85 V | 105 |
| Korrigierter Strom Phase A | 7 mA | -22 |
| Korrigierter Strom Phase B | 5 mA | -98 |
| Korrigierter Strom Phase C | 8 mA | 113 |

Durch die Korrektur des gemessenen Resonanzstromes ergeben sich wiederrum sehr geringe korrigierte Ströme (unter 10 mA), die eine verbesserte Fehlererkennung im Schutzgerät ermöglichen.

**Patentansprüche**

1. Verfahren für einen Leitungsschutz,
   bei dem

   an einer elektrischen Leitung (2,L1,L2,L3) eine Drosseleinrichtung (7,8,27-30) zur Blindleistungskompensation vorgesehen wird, und auf der Leitungsseite der Drosseleinrichtung (7,8,27-30) mittels einer ersten Messeinrichtung (9,24-26) nach Öffnen eines Leistungsschalters (5,21-23) ein Resonanzstrom ($I_{CT}$) gemessen wird,
   **dadurch gekennzeichnet, dass**
   mittels einer zweiten leitungsseitigen Messeinrichtung (10,31-33) nach Öffnen des Leistungsschalters (5,21-23) eine Spannung gemessen wird, und dass

mittels einer Auswerteeinrichtung anhand der gemessenen Spannung ein Strom ($I_{SH}$) in der Drosseleinrichtung berechnet wird, und mittels der Auswerteeinrichtung der berechnete Strom ($I_{SH}$) von dem gemessenen Resonanzstrom ($I_{CT}$) abgezogen wird, um einen korrigierten Strom ($I_{CB}$) zu erhalten.

**2.** Verfahren nach Anspruch 1, **dadurch gekennzeichnet, dass** der korrigierte Strom ($I_{CB}$) von einer Schutzeinrichtung als Eingabegröße für Leitungsschutzfunktionen verwendet wird.

**3.** Verfahren nach Anspruch 2, **dadurch gekennzeichnet, dass** für die Schutzeinrichtung ein Schwellenwert zur Bestimmung des offenen Zustands des Leistungsschalters (5) verwendet wird, wobei der Schwellenwert geringer ist als bei einer Verwendung des gemessenen Resonanzstromes ($I_{CT}$) als Eingabegrö-ße.

**4.** Verfahren nach einem der vorhergehenden Ansprüche, **dadurch gekennzeichnet, dass** für die Drosseleinrichtung (7,8,27-30) ein Main Reactor Shunt (7,27-29) und ein Neutral Reactor Shunt (8,30) verwendet wird.

**5.** Verfahren nach einem der vorhergehenden Ansprüche, **dadurch gekennzeichnet, dass** der Strom ($I_{SH}$) in der Drosseleinrichtung (7,8,27-30) für jede Phase jeweils durch eine Analyse Symmetrischer Komponenten ermittelt wird.

**6.** Schutzanordnung für einen Leitungsschutz, aufweisend eine elektrische Leitung (2,L1,L2,L3) mit einer Drosseleinrichtung (7,8,27-30) zur Blindleistungskompensation, und

einen Leistungsschalter (5,21-23) für ein zu- oder abschalten der Leitung (2,L1,L2,L3), und
eine auf der Leitungsseite der Drosseleinrichtung (7,8,27-30) angeordnete erste Messeinrichtung (9,24-26) zum Messen eines nach Öffnen des Leistungsschalters (5,21-23) fließenden Resonanzstromes ($I_{CT}$),
**dadurch gekennzeichnet, dass**
eine zweite leitungsseitige Messeinrichtung (10,31-33) ausgebildet ist, nach Öffnen des Leistungsschalters (5,21-23) eine Spannung zu messen, und dass
eine Auswerteeinrichtung ausgebildet ist, anhand der gemessenen Spannung einen Strom ($I_{SH}$) in der Drosseleinrichtung (7,8,27-30) zu berechnen, und den berechneten Strom ($I_{SH}$) von dem gemessenen Resonanzstrom ($I_{CT}$) abzuziehen, um einen korrigierten Strom ($I_{CB}$) zu erhalten.

**7.** Schutzanordnung nach Anspruch 6, **dadurch gekennzeichnet, dass** eine Schutzeinrichtung ausgebildet ist, den korrigierten Strom ($I_{CB}$) als Eingabegröße für Leitungsschutzfunktionen zu verwenden.

**8.** Schutzanordnung nach Anspruch 7, **dadurch gekennzeichnet**, die Schutzeinrichtung ausgebildet ist, einen Schwellenwert zur Bestimmung des offenen Zustands des Leistungsschalters (5,21-23) zu verwenden, wobei der Schwellenwert geringer ist als bei einer Verwendung des gemessenen Resonanzstromes ($I_{CT}$) als Eingabegröße.

**9.** Schutzanordnung nach einem der Ansprüche 6 bis 8, **dadurch gekennzeichnet, dass** die Drosseleinrichtung (7,8,27-30) einen Main Reactor Shunt (7,27-29) und einen Neutral Reactor (8,30) Shunt aufweist.

**10.** Schutzanordnung nach einem der Ansprüche 6 bis 9, **dadurch gekennzeichnet, dass** mittels der Auswerteeinrichtung der Strom ($I_{SH}$) in der Drosseleinrichtung (7,8,27-30) für jede Phase jeweils durch eine Analyse Symmetrischer Komponenten ermittelt wird.

**Claims**

**1.** Method for protecting lines,
in which

a reactor device (7, 8, 27-30) for reactive power compensation is provided on an electrical line (2, L1, L2, L3), and a resonant current ($I_{CT}$) is measured on the line side of the reactor device (7, 8, 27-30) by means of a first measuring device (9, 24-26) after opening of a circuit breaker (5, 21-23),
**characterized in that**
a voltage is measured by means of a second line-side measuring device (10, 31-33) after opening of the circuit breaker (5, 21-23), and **in that**
a current ($I_{SH}$) in the reactor device is calculated by means of an evaluation device on the basis of the measured voltage, and the calculated current ($I_{SH}$) is subtracted from the measured resonant current ($I_{CT}$) by means of the evaluation device in order to obtain a corrected current ($I_{CB}$).

2. Method according to Claim 1, **characterized in that** the corrected current ($I_{CB}$) is used by a protection device as input variable for line protection functions.

3. Method according to Claim 2, **characterized in that** a threshold value for determining the open state of the circuit breaker (5) is used for the protection device, wherein the threshold value is lower than in the case of the use of the measured resonant current ($I_{CT}$) as input variable.

4. Method according to one of the preceding claims, **characterized in that** a main reactor shunt (7, 27-29) and a neutral reactor shunt (8, 30) are used for the reactor device (7, 8, 27-30).

5. Method according to one of the preceding claims, **characterized in that** the current ($I_{SH}$) in the reactor device (7, 8, 27-30) is determined for each phase in each case by an analysis of symmetrical components.

6. Protection assembly for protecting lines, having an electrical line (2, L1, L2, L3) having a reactor device (7, 8, 27-30) for reactive power compensation, and

   a circuit breaker (5, 21-23) for connecting or disconnecting the line (2, L1, L2, L3), and
   a first measuring device (9, 24-26), which is arranged on the line side of the reactor device (7, 8, 27-30), for measuring a resonant current ($I_{CT}$) flowing after opening of the circuit breaker (5, 21-23),
   **characterized in that**
   a second line-side measuring device (10, 31-33) is designed to measure a voltage after opening of the circuit breaker (5, 21-23), and **in that**
   an evaluation device is designed to calculate a current ($I_{SH}$) in the reactor device (7, 8, 27-30) on the basis of the measured voltage, and to subtract the calculated current ($I_{SH}$) from the measured resonant current ($I_{CT}$) in order to obtain a corrected current ($I_{CB}$).

7. Protection assembly according to Claim 6, **characterized in that** a protection device is designed to use the corrected current ($I_{CB}$) as input variable for line protection functions.

8. Protection assembly according to Claim 7, **characterized in that** the protection device is designed to use a threshold value for determining the open state of the circuit breaker (5, 21-23), wherein the threshold value is lower than in the case of the use of the measured resonant current ($I_{CT}$) as input variable.

9. Protection assembly according to one of Claims 6 to 8, **characterized in that** the reactor device (7, 8, 27-30) has a main reactor shunt (7, 27-29) and a neutral reactor shunt (8, 30) .

10. Protection assembly according to one of Claims 6 to 9, **characterized in that** the current ($I_{SH}$) in the reactor device (7, 8, 27-30) is determined by means of the evaluation device for each phase in each case by an analysis of symmetrical components.

**Revendications**

1. Procédé de protection d'une ligne,
   dans lequel

   on prévoit sur une ligne (2, L1, L2, L3) électrique un dispositif (7, 8, 27 à 30) de bobine pour la compensation de la puissance réactive et on mesure du côté de la ligne du dispositif (7, 8, 27 à 30) de bobine un courant ($I_{CT}$) de résonnance au moyen d'un premier dispositif (9, 24 à 26) de mesure après ouverture d'un disjoncteur (5, 21 à 23),
   **caractérisé en ce que**
   au moyen d'un deuxième dispositif (10, 31 à 33) de mesure du côté de la ligne, on mesure après l'ouverture du disjoncteur (5, 21 à 23) une tension et **en ce que**
   au moyen d'un dispositif d'analyse, on calcule à l'aide de la tension mesurée, un courant ($I_{SH}$) dans le dispositif de bobine et au moyen du dispositif d'analyse, on soustrait le courant ($I_{SH}$) calculé du courant ($I_{CT}$) de résonnance mesuré pour obtenir un courant ($I_{CB}$) corrigé.

2. Procédé suivant la revendication 1, **caractérisé en ce qu'**on utilise le courant ($I_{CB}$) corrigé par un dispositif de protection comme grandeur d'entrée pour des fonctions de protection de ligne.

3. Procédé suivant la revendication 2, **caractérisé en ce que** l'on utilise pour le dispositif de protection une valeur de seuil pour la détermination de l'état ouvert du disjoncteur (5), dans lequel la valeur de seuil est plus petite que lors d'une utilisation du courant ($I_{CT}$) de résonnance mesuré comme grandeur d'entrée.

4. Procédé suivant l'une des revendications précédentes, **caractérisé en ce que** l'on utilise pour le dispositif (7, 8, 27 à 30) de bobine un Main Reactor Shunt (7, 27 à 29) et un Neutral Reactor Shunt (8, 30).

5. Procédé suivant l'une des revendications précédentes, **caractérisé en ce que** l'on détermine le courant ($I_{SH}$) dans le dispositif (7, 8, 27 à 30) de bobine pour chaque phase respectivement par une analyse de composantes symétriques.

6. Agencement de protection pour une protection de ligne comportant une ligne (2, L1, L2, L3) électrique ayant un dispositif (7, 8, 27 à 30) de bobine pour la compensation de la puissance réactive, et

   un disjoncteur (5, 21 à 23) pour mettre la ligne (2, L1, L2, L3) circuit ou hors circuit, et
   un premier dispositif (9, 24 à 26) de mesure monté du côté de la ligne du dispositif (7, 8, 27 à 30) de bobine pour la mesure d'un courant ($I_{CT}$) de résonnance passant après l'ouverture du disjoncteur (5, 21 à 23), **caractérisé en ce que**
   un deuxième dispositif (10, 31 à 33) de mesure du côté de la ligne est constitué pour mesurer une tension après l'ouverture du disjoncteur (5, 21 à 23), et **en ce que**
   un dispositif d'analyse est constitué pour calculer à l'aide de la tension mesurée un courant ($I_{SH}$) dans le dispositif (7, 8, 27 à 30) de bobine et pour soustraire le courant ($I_{SH}$) calculé du courant ($I_{CT}$) de résonnance mesuré afin d'obtenir un courant ($I_{CB}$) corrigé.

7. Agencement de protection suivant la revendication 6, **caractérisé en ce qu'**un dispositif de protection est constitué pour utiliser le courant ($I_{CB}$) corrigé comme grandeur d'entrée pour des fonctions de protection de ligne.

8. Agencement de protection suivant la revendication 7, **caractérisé en ce que** le dispositif de protection est constitué pour utiliser une valeur de seuil pour la détermination de l'état ouvert du disjoncteur (5, 21 à 23), dans lequel la valeur de seuil est plus petite que lors d'une utilisation du courant ($I_{CT}$) de résonnance mesuré comme grandeur d'entrée.

9. Agencement de protection suivant l'une des revendications 6 à 8, **caractérisé en ce que** le dispositif (7, 8, 27 à 30) de bobine comporte un Main Reactor Shunt (7, 27 à 29) et un Neutral Reactor (8, 30) Shunt.

10. Agencement de protection suivant l'une des revendications 6 à 9, **caractérisé en ce que** l'on détermine respectivement par une analyse de composantes symétriques pour chaque phase le courant ($I_{SH}$) dans le dispositif (7, 8, 27 à 30) de bobine au moyen du dispositif d'analyse.

## FIG 1

## FIG 2

FIG 3

41                                42                                43

V1   | Z sh |  I1       V2   | Z sh |  I2       V0   | 3 x ZN sh |  I0

| Z sh |

# FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3629437 A1

**In der Beschreibung aufgeführte Nicht-Patentliteratur**

- SIPROTEC 7SD87 Leitungsdifferentialschutz. Siemens AG, 2018

- SIPROTEC 5 Schutz, Automatisierung und Überwachung. Siemens AG, 2016